# EUROPEAN PATENT SPECIFICATION

(11) **EP 1 716 949 B1**
(45) Date of publication and mention of the grant of the patent: **27.08.2008**
(21) Application number: 06252129.9
(22) Date of filing: 19.04.2006
(51) Int. Cl.: B23B 15/00, C07F 9/06, C23F 11/00, C23C 22/00

(54) **Immersion method**
Eintauchverfahren
Procédé d'immersion

(30) Priority: 20.04.2005 GB 0507887
(43) Date of publication of application: 02.11.2006
(73) Proprietor: Rohm and Haas Electronic Materials, L.L.C., Marlborough, Massachusetts 01752 (US)
(72) Inventor: Lau, Danny, Fanling, N.T. Hong Kong (HK); Kwok, Raymund W. M., Cho Kwo Ling Kowloon Hong Kong (HK); Ting, Fai Lung, Fanling, N.T. Hong Kong (HK); Crosby, Jeffrey N., Nuneaton Warwickshire CV11 6YB (GB)
(74) Representative: Kent, Venetia Katherine

(56) References cited:
- EP-A- 0 342 621
- GB-A- 1 386 746
- US-A- 3 088 910
- US-A- 3 123 582
- US-A- 3 146 208
- US-A- 3 532 639
- US-A- 4 752 556
- US-A- 4 929 490
- US-A1- 2004 000 355
- US-A1- 2004 070 084
- US-B1- 6 740 173

## Description

The present invention is directed to an immersion method and composition for inhibiting corrosion of metals and metal alloys. More specifically, the present invention is directed to an immersion method and composition for inhibiting corrosion of metals and metal alloys using inorganic and organic acids.

Prevention of corrosion of metals and metal alloys is a challenging problem in numerous industries. The corrosion of metal and metal alloys has been especially problematic in the electronic materials industry where corrosion may lead to faulty electrical contact between components in electronic devices. The steel industry has also suffered from the corrosion problem. For example, electroplated tin and tin alloy coatings have been used in electronics and other applications such as wire, and steel strip for many years. In electronics, they have been used as a solderable and corrosion resistive surface for contacts and connectors. They are also used in lead finishes for integrated circuit ("IC") fabrication. In addition, a thin layer of tin or tin alloy is applied as the final step for passive components such as capacitors and transistors.

Though applications vary, there are some commonalities regarding the requirements for this final surface finish. One issue is long term solderability, defined as the ability of the surface finish to melt and make a good solder joint to other components without defects that impair the electrical or mechanical connection. Soldering is basically an attachment procedure that usually involves three materials: (1) the substrate, (2) the component or other device which is desired to be attached to the substrate, and (3) the soldering material itself. The soldering material itself is a tin or tin alloy. The substrate or component/device may be made of other metals.

There are many factors that determine good solderability, the three most important of which are extent of surface oxide formation (corrosion), amount of co-deposited carbon, and extent of intermetallic compound formation. Surface oxide formation is a natural occurring process because it is thermodynamically favorable. The rate of formation of the surface oxide depends on the temperature and time. The higher the temperature and the longer the exposure time, the thicker the surface oxide formed. In electroplated tin or tin alloy coatings or deposits, surface oxide formation also depends on the surface morphology of the coating or deposit. When comparing pure tin to tin alloy coatings, for example, tin alloys generally form less or thinner surface oxides when all other conditions are equal.

Co-deposited carbon is determined by the plating chemistry one chooses to use. Bright finishes contain higher carbon contents than matte finishes. Matte finishes are normally rougher than bright finishes, and provide an increased surface area which results in the formation of more surface oxides than typically are formed with bright finishes.

Intermetallic compound formation is a chemical reaction between the tin or tin alloy coating and the substrate. The rate of formation depends on temperature and time as well. Higher temperatures and longer times result in a thicker layer of intermetallic compounds.

To ensure solderability, it is important to 1) deposit a sufficient layer of tin or tin alloy such that surface oxide or intermetallic compound formation does not consume the entire layer, and 2) to prevent or minimize exposure of the tin plated surface to elevated temperatures for extended periods of time.

It is relatively easy to achieve 1), but it is difficult to achieve 2). The temperature and the time of subsequent post treatment after plating of a tin or tin alloy deposit are typically dictated by the assembly specifications and existing manufacturing layout and practice. For example, in "two tone" leadframe technology, after the tin or tin alloy plating, the entire package goes through many process steps (i.e., a long period of time for such treatments) which require multiple thermal excursions at temperatures as high as 175° C. Inevitably, more and thicker surface oxide forms, and this in turn reduces the solderability of the tin or tin alloy deposit. In current processing, these additional steps may not be omitted since the final components and assemblies would not be complete. Therefore, it is desirable to find ways to prevent or minimize surface oxide formation on such parts.

One method of addressing the surface oxide problem is to introduce a conformal coating on the surface of the tin or tin alloy deposits. This technology may be summarized in two general categories: one that applies a precious metal coating and the other that applies an organic coating. The first category is undesirable for the protection of tin or tin alloy deposits because it introduces an expensive, extra step. The second category also is undesirable because it may introduce impurities onto other critical areas of the leadframe or electrical component due to the non-selective nature of the organic coating that is deposited. Such impurities are detrimental to subsequent leadframe and IC assembly process.

U.S. 2004/0099340 (WO 2004/050959) to Zhang et al. attempts to address the surface oxide problem on metal and metal alloy deposits by incorporating trace amounts of phosphorous in the deposits. Zhang et al. allege that incorporating phosphorous into the deposits reduces the formation of surface oxide on the deposits. The phosphorous compounds are included in the metal and metal alloy electroplating baths, and are codeposited with the metal or metal alloy. The preferred source of phosphorous is the hypophosphites such as NaH₂PO₄. A disadvantage of such a method is the inclusion of the hypophosphites in the baths. The more components that are added to a bath, the more likely it is to have undesirable interactions in the bath. The hypophosphite may interact with other functional additives, which may compromise the grain size, crystal orientation, ductility, hardness, and conductivity of the deposit.

US2005/0000355A1 and US 2004/0070084A1 disclose the use of fluxes for soldering. US4929490 disclose aminotrismethyl phosphoric acid as rustproofing agent.

Although there are methods and compositions which address the surface oxide problem on metal and metal alloy deposits, there is still a need for improved compositions and methods for inhibiting surface oxide formation on metals and metal alloys.

The present invention in its various aspects is as set out in the appended claims.

Compositions are provided composed of phosphoric acids or salts thereof in amounts to inhibit oxide formation on metals and metal alloys, and water. In addition to inhibiting oxide formation on metals and metal alloys, the compositions provide a stable grain structure for subsequent soldering. The oxide formation is undesirable since it may cause electrical malfunctions of metal components in electrical devices compromising the performance of the devices. Additionally, the compositions do not contaminate the metals and metal alloys they treat.

In a further embodiment, methods include contacting metals or metal alloys with phosphoric acids or salts thereof to inhibit oxide formation on the metals or metal alloys.

In an additional embodiment a method includes depositing one or more metals or metal alloys on a substrate; contacting the one or more metals or metal alloys with a composition including phosphoric acids or salts thereof; and reflowing the one or more metals or metal alloys. The method inhibits the formation of oxide on the metals and metal alloys.

As used throughout this embodiment, the following abbreviations have the following meanings, unless the context clearly indicates otherwise: °C = degrees Centigrade; g = gram; L = liter; mL = milliliter; ASD = amperes/dm²; sec. = seconds; µm = microns; min. = minutes; wt% = weight percent; v/v = volume to volume; and DI = deionized. The terms "depositing" and "plating" are used interchangeably throughout this specification.

Compositions are composed of phosphoric acids or salts thereof, and water. The compositions inhibit corrosion on metals and metal alloys, and provide a stable grain structure on the surface of the metals and metal alloys for subsequent soldering. Such corrosion is in the form of an oxide which forms on the metals and metal alloys. Typically it forms on a surface of the metals and metal alloys and is discernable by a discoloration. In addition the compositions do not contaminate the metals and metal alloys when they are applied to the metals and metal alloys.

The phosphoric acids or salts thereof and mixtures thereof inhibit oxide formation on metals and metal alloys. Such phosphoric acids include inorganic phosphoric acids such as phosphoric acid (H₃PO₄), also known as orthophosphoric acid, and polyphosphoric acids. Inorganic phosphoric acids may be represented by the formula: Hₙ₊₂PₙO₃ₙ₊₁, where n is an integer of 1 or greater. When n is an integer of 2 or greater, the formula represents a polyphosphoric acid. When the inorganic phosphoric acid is a polyphosphoric acid, typically, n is an integer such that the polyphosphoric acid has an average molecular weight of 110 to 1,500 atomic weight units.

Salts of phosphoric acids such as sodium phosphate and potassium phosphate may be used. The salts include the dibasic sodium phosphate, tribasic sodium phosphate, dibasic potassium phosphate and tribasic potassium phosphate. Salts of the polyphosphoric acids also may be used. Mixtures of the inorganic phosphoric acids and their salts also may be included in the compositions. Such acids are commercially available, or may be made according to methods described in the literature.

The inorganic phosphoric acids and their salts are included in the compositions in amounts to inhibit formation of oxides on metals and metal alloys. For example, the inorganic phosphoric acids and their salts may be included in the compositions in amounts of 0.1 gm/L to 1500 gm/L, or such as from 0.5 gm/L to 1000 gm/L, or such as from 1 gm/L to 500 gm/L, or such as from 10 gm/L to 100 gm/L, or such as 20 gm/L to 50 gm/L.

In addition to the inorganic phosphoric acids one or more organic phosphoric acids is used which are aminotris(alkylene-phosphoric) acids and salts thereof. Such phosphoric acids are commercially available, or may be made according to methods described in the literature.

An example of an aminotris(alkylene-phosphoric) acid is aminotris(methylene-phosphoric) acid.

Typically, the aminotris(methylene-phosphoric) acids are used as the organic phosphoric acid, for example aminotris(methylene-phosphoric) acid.

The organic phosphoric acids and their salts are included in the compositions in amounts of 0.005 gm/L to 1 gm/L, or such as from 0.01 gm/L to 0.5 gm/L, or such as from 0.1 gm/L to 0.25 gm/L.

Optionally, phosphorous acid (H₃PO₃) may be included in the formulation. Phosphorous acid may be included in amounts of 0.1 g/L to 1 g/L.

The compositions are aqueous and are applied to metals and metal alloys to inhibit the formation of oxides on the metals and the metal alloys. The pH of the compositions is from 1 to 6, or such as from 2 to 4. The compositions may be applied on any metal and metal alloy where oxide formation may be inhibited. Examples of such metals include tin, copper, nickel, silver and alloys thereof. Typically the compositions are used to inhibit oxide formation on tin and its alloys. Examples of tin alloys include tin/lead, tin/copper, tin/silver, tin/silver/copper, tin/nickel, tin/bismuth and tin/gold. More typically they are used to inhibit oxide formation on tin and tin/lead. Most typically they are used to inhibit oxide formation on tin.

The compositions may be applied to the metals and metal alloys at any period after the metals and metal alloys are deposited on a substrate. Typically they are applied right after the metal or metal alloy plating as a post-treatment process. The oxidation inhibiting action of the compositions may last days after the post-treatment and still be effective when the metal or metal alloy is reflowed. Accordingly, the treated metal or metal alloy may be stored or transported and reflowed latter and still inhibit oxidation.

Tin may form tin oxide (SnO) after reflow. This is noticeable on the deposited tin after the reflow process by a discoloration of the tin surface. The longer the exposure of the reflowed tin to oxygen and the higher the temperature, the more noticeable is the discoloration. Typically the discoloration is observable as a yellow tint on the surface of the tin. In more severe cases of oxidation, the tin may appear brown and even purple after reflow. Oxidation of the tin may result in poor electrical conduction or shorts in electronic devices where the tin is plated such as in printed wiring boards and leadframes. In addition, the presence of oxidation on the tin or tin alloy surface compromises any subsequent soldering process of the tin or tin alloy. Poor soldering may result in separation of the soldered parts resulting in malfunction of the electronic device. The compositions inhibit the undesirable oxidation, provide a stable grain structure on the surface of the tin, and do not contaminate the tin surface.

The compositions may be applied to the metals and metal alloys by any suitable method in the art. For example, the compositions may be sprayed on the metals and metal alloys or the metals and metal alloys may be immersed in the compositions. Typically, the metals and metal alloys are immersed in the compositions. Generally, the compositions are at temperatures of 18° C to 60° C, or such as from 20° C to 50° C, or such as from 25° C to 40° C.

The amount of time the metals and metal alloys are exposed to the oxide inhibiting composition may vary. Typically, the metals and metal alloys are in contact with the compositions for at least 5 sec. before any subsequent processing steps. More typically, the metals and metal alloys are in contact with the composition for 5 sec to 60 sec., or such as from 10 sec. to 30 sec. The metals and metal alloys may then be optionally rinsed with water to remove any excess oxide inhibiting composition.

A reflow process may follow the treatment and rinse step. Any suitable reflow process may be used. Reflow may be by heating by vapor phase reflow, laser reflow, plasma, oven melting, and passing an electrical current through the metals and metal alloys, or by any other method of heating the metals and metal alloys above their liquidus temperature.

The compositions may be used with any suitable metal deposition process such as electrolytic metal deposition or electroless metal deposition. The compositions may be used to inhibit oxidation of metals and metal alloys used in the manufacture of any article which is made with electrolytically or electrolessly deposited metals. Examples of such articles include printed wiring boards, connectors, passive components, bumps on wafers and leadframes

In one embodiment, a substrate, such as a printed wiring board, connectors or leadframe, optionally may be cleaned prior to metallization. Any suitable cleaning process may be used which is acceptable in the metallization arts. Typically, the substrate is ultrasonically cleaned in a suitable solution. Such cleaning solutions may include silicate compounds, alkali metal carbonates and other components such as alkali metal hydroxides, glycol ethers and one or more chelating agents.

Optionally, following the cleaning step, the substrate may be activated with a suitable acid such as a mineral acid. An example of such an acid is sulfuric acid. However, other mineral acids may be used. The acids are used in conventional concentrations well known in the art.

The substrate may then be plated with a metal such as tin, copper, nickel, silver or an alloy thereof or, for example, tin may be plated on nickel or tin on copper. Any suitable metal or metal alloy plating bath may be used. For example, a typical tin plating bath may include one or more water soluble tin salts such as tin sulfate, tin alkyl sulfonates such as tin sulfonate, tin alkanol sulfonic acid, and tin halides such as tin chloride. The bath also includes electrolytes such as sulfuric acid, alkyl sulfonates, alkanol sulfonates and halide salts to provide an electro-conductive matrix. Surfactants also may be included as well as other conventional additives to provide a desirable tin layer. The amounts of the components are conventional and are well known in the art and may be obtained from the literature. U.S. 5,174,887 and U.S. 5,871,631 disclose suitable tin electroplating baths. U.S. 4,880,507 and U.S. 4,994,155 disclose suitable tin/lead plating baths.

A suitable copper electrolytic bath may include one or more water soluble copper salts such as copper sulfate pentahydrate, a sulfuric acid matrix to provide electrical conduction in the bath, chloride ions from sodium chloride or hydrogen chloride, levelers, carriers, brighteners and other additives such as surfactants to provide the desired copper metal layers. The amounts of such components are conventional and are well know in the art and the literature. U.S. 6,652,731 discloses a suitable copper metal electrolyte for electrolytic deposition.

Any suitable nickel bath may be used. A nickel bath may include one or more water soluble nickel salts such as nickel chloride, nickel sulfate hexahydrate, and nickel sulfamate tetrahydrate. One or more acids such as boric acid and ascorbic acid may be included. Additionally, one or more conventional additives may be included to provide a desired nickel layer. The amounts of the components may be conventional and are well known in the art, or may be obtained from the literature. An example of a suitable nickel electroplating solution is disclosed in U.S. 6,858,122.

The metals may be deposited at any suitable temperature and current density depending on the metal or metal alloy plated. Generally, the bath temperatures range from 15° C to 40° C, or such as from 25° C to 30° C. The current density is typically from 1 ASD to 35 ASD, or such as from 5 ASD to 30 ASD, or such as from 10 ASD to 20 ASD. However, any conventional current density used to plate tin, copper, nickel or alloys thereof may be used. Suitable current densities are disclosed in the literature.

After the metals or metal alloys are deposited on the substrates, they undergo post-metallization treatment with the oxide inhibition compositions as described above. The treated metals or metal alloys may then be reflowed by one of the methods described above. After reflow the metal or metal alloy plated substrate may be further processed as desired.

### Working Example 1 (Comparative)

Twelve (12) brass connectors were ultrasonically cleaned at 65° C for 30 sec. in a cleaning solution containing 100 g/L of RONACLEAN™ GP-300LF(SE), which is a silicate containing cleaning composition (obtainable from Rohm and Haas Electronic Materials L.L.C., Marlborough, MA, USA).

After cleaning, each brass connector was removed from the cleaning solution and activated with technical grade sulfuric acid. The brass connectors were immersed in a 100 mL/L of the technical grade sulfuric acid at room temperature for 10 sec. Each brass connector was then nickel plated.

The 12 brass connectors were joined in electrical communication with a rectifier and an insoluble electrode which functioned as an anode. The brass connectors functioned as cathodes. The anode and the 12 brass connectors were placed in an electrolytic nickel plating solution to complete the circuit. The nickel plating solution was an aqueous solution which included 700mL/L of nickel sulfamate solution (180 g/L) and 8 g/L of nickel chloride concentrate (500 g/L) to provide an electroplating solution containing 115 g/L to 135 g/L of nickel ions.

The brass connectors were plated with a 1 µm layer of nickel. Electroplating was done at 55° C at a current density of 10 ASD for 120 sec. The nickel plated brass connectors were then removed from the nickel electrolytic solution, rinsed with water and then plated with tin.

Each nickel plated brass connector was then placed in a tin electrolyte solution and joined in electrical communication with a rectifier and an insoluble electrode, which functioned as the anode. The nickel plated brass connectors functioned as cathodes. The tin electrolyte included 60 gm/L of tin ions from tin methane sulfonate and 150 mL/L of 70% methane sulfonic acid as the matrix. The temperature of the tin bath was 15° C during tin deposition.

The current density during tin deposition was 10 ASD. Tin plating was done for 30 sec. and a tin layer of 2µm was deposited on the nickel layer of each brass connector. The tin layer appeared smooth and bright.

A stock solution of an immersion acid oxide inhibitor composition was prepared by mixing 1200 gm of technical grade (85%) phosphoric acid and 100 gm of aminotris(methylene-phosphoric) acid in water to make a one liter aqueous solution. A 20% v/v aqueous immersion acid composition was then made from the stock solution to be used for a tin plating post treatment.

A control post treatment composition also was prepared. It included 40% sodium hydroxide, 30% sodium carbonate, 20% sodium metasilicate and 10% sodium tripolyphosphate. The solid materials were mixed with sufficient water to make a 10 g/L solution.

Nine (9) of the tin and nickel plated brass connectors were immersed in the 20%v/v oxide inhibitor composition for 5 sec. at 50° C. They were then removed and rinsed with water, and then hot air dried at 100° C. Each of the 9 tin and nickel plated brass connectors were than reflowed.

Three (3) of the tin and nickel plated brass connectors were placed in a Sikama Falcon™ 8500 conduction/convection oven to reflow their tin layers. The temperature profile was 125° C to 180° C to 240° C to 260° C to 240° C and then cool down to room temperature. Each connector remained in each temperature zone for 30 sec. After reflow, the connectors were examined for oxidation. A visual scale of 0 to 5 was used. If no visible oxidation was observed, the connector was rated 0; and if there was serious discoloration, the connector was given a 5. One of the connectors was free of any discoloration (0). One had a slight yellow tint (1). One had severe discoloration, which was noticeable by a distinct yellowing of the reflowed tin layer (4).

Three (3) of the tin and nickel plated brass connectors were placed in the Sikama Falcon™ 8500 conduction/convection oven and reflowed using the same temperature profile and dwell times as the first set of connectors except that they were reflowed twice. The 3 connectors were then allowed to cool to room temperature and their tin surfaces were observed for signs of oxidation. One of the connectors was free of any visible tin oxidation (0). One had severe tin oxidation (4), and one showed a slight yellow tint (1).

The remaining 3 tin and nickel plated brass connectors, which were treated with the immersion acid composition, were placed in the same conduction/convection oven as the first six but were reflowed three times using the temperature profile above and the dwell times. All three were removed from the oven after reflow and allowed to cool to room temperature. One of the connectors was free of any visible signs of surface oxidation (0). One showed discoloration (4), and one showed noticeable, but not severe discoloration (2).

The 3 remaining connectors were immersed in the control treatment solution described above. Each connector remained in the solution for 5 sec. at a temperature of 50° C. After they were removed from the treatment solution, they were rinsed with water and hot air dried at 100° C. One was reflowed once using the oven and temperature profile with dwell times described above. The second was reflowed twice and the third was reflowed three times using the temperature profile and dwell times described above.

Each control connector was removed from the oven after the reflow cycle and allowed to cool to room temperature. Visible observation of each connector showed severe discoloration (4).

Although some of the tin and nickel plated brass connectors treated with the acid immersion composition showed discoloration, there were still 3 which were completely free of any visible signs of tin oxidation. Additionally, 3 of the connectors showed minor discoloration, while only 3 showed severe discoloration. In contrast, all three of the control connectors treated with the control treatment solution showed severe discoloration. Accordingly, the immersion acid composition containing an inorganic phosphoric acid and an organic phosphoric acid showed improvement in preventing tin oxidation over the controls.

### Working Example 2

Sixteen (16) brass connectors were ultrasonically cleaned at 65° C for 30 sec. in a cleaning solution containing 100 g/L of RONACLEAN™ CP-100S, which is a silicate containing cleaning composition (obtainable from Rohm and Haas Electronic Materials L.L.C., Marlborough, MA USA).

After cleaning, each brass connector was removed from the cleaning solution and activated with technical grade sulfuric acid. The brass connectors were then immersed in a 100 mL/L of the technical grade sulfuric acid at room temperature for 10 sec. Each brass connector was then nickel plated.

The 16 brass connectors were joined in electrical communication with a rectifier and an insoluble electrode which functioned as an anode. The brass connectors functioned as cathodes. The anode and the 16 brass connectors were placed in an electrolytic nickel plating solution to complete the circuit. The nickel plating solution was an aqueous solution which included 700 mL/L of nickel sulfamate solution (180 g/L) and 8 g/L of nickel chloride concentrate (500 g/L) to provide an electroplating solution containing 115 g/L to 135 g/L of nickel ions.

The brass connectors were plated with a 1 µm layer of nickel. Electroplating was done at 55° C at a current density of 10 ASD for 120 sec. The nickel plated brass connectors were then removed from the nickel electrolytic solution, rinsed with water and then plated with tin.

Each nickel plated brass connector was then placed in tin electrolyte baths and joined in electrical communication with a rectifier and an insoluble electrode, which functioned as the anode. The nickel plated brass connectors functioned as cathodes. The tin electrolyte baths included 60 gm/L of tin ions from tin methane sulfonate and 150 mL/L of 70% methane sulfonic acid as the matrix. All sixteen connectors were plated with tin at 15° C.

Eight (8) of the connectors in the tin baths were tin plated at a current density of 10 ASD, and 8 of the connectors were tin plated at a current density of 15 ASD. Tin plating was done in each bath for 30 sec. to form a bright tin layer of 2 µm on the nickel layer of each brass connector. After tin plating, the tin and nickel plated brass connectors were removed from their respective baths and rinsed with water and then air dried at room temperature.

A stock solution of an immersion acid oxide inhibitor was prepared by mixing 1200 gm of technical grade (85%) phosphoric acid and 100 gm of aminotris(methylene-phosphoric) acid in water to make a one liter aqueous solution. From the stock solution, dilute solutions of 5% v/v, 10% v/v, 20% v/v and 30% v/v were made to treat the tin and nickel plated brass connectors.

Each of the diluted immersion oxide inhibiting compositions was used to treat one connector tin plated at 10 ASD and 20° C and one connector at 15 ASD and 20° C and another pair at 50° C. Each tin and nickel plated connector was immersed in the compositions for 5 sec. They were then removed and hot air dried at 100° C.

Each of the treated connectors was then placed in a Sikama Falcon™ 8500 conduction/convection oven for reflow of the tin layers. The temperature profile was 125° C to 180° C to 240° C to 260° C to 240° C and then back down to room temperature. The connectors dwelled in each temperature zone for 30 sec. After reflow, the connectors were visibly examined for any tin oxide formation.

The visible examination of each of the connectors showed no serious discoloration on any of the connectors. Minor discoloration was observed on 4 of the 8 connectors plated with tin at 15 ASD. In contrast, 2 of the connectors plated with tin at 10 ASD showed minor discoloration. Accordingly, the immersion acid oxide inhibiting compositions inhibit the formation of tin oxide on tin plated substrates after reflow.

## Claims

1. A method comprising:
a. depositing one or more metals on a substrate, the metals are selected from the group consisting of tin, copper, nickel, silver and alloys thereof;
b. contacting the one or more metals with a composition consisting of one or more inorganic phosphoric acids or salts thereof in amounts of 0.1 gm/L to 1500 gm/L and one or more aminotris(alkylene-phosphoric) acids or salts thereof in amounts of 0.005 gm/L to 1 gm/L, and water to inhibit oxidation of the one or more metals; and
c. reflowing the one or more metals.

2. The method of claim 1, wherein the one or more metals are deposited on the substrate electrolytically.

3. The method of claim 1, wherein the metal is tin, or tin alloy.

4. The method of claim 1, wherein the substrate is a printed wiring board, lead frame or connector.

## Patentansprüche

1. Verfahren, umfassend
a) das Abscheiden von einem oder mehreren Metallen auf einem Substrat, wobei die Metalle aus der Gruppe, bestehend aus Zinn, Kupfer, Nickel, Silber und Legierungen davon, ausgewählt ist,
b) das Inkontaktbringen des einen oder der mehreren Metalle mit einer Zusammensetzung, bestehend aus einer oder mehreren anorganischen Phosphorsäuren oder Salzen davon in Mengen von 0,1 g/L bis 1.500 g/L und einer oder mehreren Aminotris(alkylenphosphor)säuren oder Salzen davon in Mengen von 0,005 g/L bis 1 g/L, und Wasser, um die Oxidation des einen oder der mehreren Metalle zu inhibieren, und
c) das Aufschmelzen des einen oder der mehreren Metalle.

2. Verfahren nach Anspruch 1, wobei das eine oder die mehreren Metalle elektrolytisch auf dem Substrat abgeschieden werden.

3. Verfahren nach Anspruch 1, wobei das Metall Zinn oder eine Zinnlegierung ist.

4. Verfahren nach Anspruch 1, wobei das Substrat eine Leiterplatte, ein Leiterrahmen oder ein Steckverbinder bzw. Konnektor ist.

## Revendications

1. Procédé comprenant les étapes consistant à :
a. déposer un ou plusieurs métaux sur un substrat, les métaux étant choisis dans le groupe constitué de l'étain, du cuivre, du nickel, de l'argent et d'alliages de ceux-ci ;
b. mettre en contact les un ou plusieurs métaux avec une composition constituée d'un ou plusieurs acides phosphoriques inorganiques ou sels de ceux-ci en des quantités de 0,1 gm/L à 1 500 gm/L et d'un ou plusieurs acides aminotris(alkylène-phosphorique) ou sels de ceux-ci en des quantités de 0,005 gm/L à 1 gm/L, et d'eau pour inhiber l'oxydation des un ou plusieurs métaux ; et
c. mettre au reflux les un ou plusieurs métaux.

2. Procédé selon la revendication 1, dans lequel les un ou plusieurs métaux sont déposés sur le substrat de manière électrolytique.

3. Procédé selon la revendication 1, dans lequel le métal est l'étain ou un alliage d'étain.

4. Procédé selon la revendication 1, dans lequel le substrat est une carte de circuit imprimé, une grille de connexion ou un connecteur.
